# EUROPEAN PATENT APPLICATION

(11) **EP 4 783 754 A1**
(43) Date of publication of application: **29.07.2026**
(21) Application number: 24868057.1
(22) Date of filing: 28.08.2024
(51) Int. Cl.: H05K 1/05

(54) **LAMINATE MANUFACTURING APPARATUS AND LAMINATE MANUFACTURING METHOD**

(30) Priority: 21.09.2023 JP 2023154191
(71) Applicant: NHK Spring Co., Ltd., Yokohama-shi, Kanagawa 236-0004 (JP)
(72) Inventor: MIZUNO, Katsumi, Yokohama-shi, Kanagawa 236-0004 (JP); WATANABE, Toshinori, Yokohama-shi, Kanagawa 236-0004 (JP); SHIMOMURA, Kohei, Yokohama-shi, Kanagawa 236-0004 (JP); TOGA, Takashi, Yokohama-shi, Kanagawa 236-0004 (JP)
(74) Representative: TBK
(86) International application number: PCT/JP2024/030715
(87) International publication number: WO 2025/062977

(57) **Abstract**

Proposed is a laminate production tool for a laminate including a circuit pattern having a thickness of 0.8 mm or more, enabling prevention of a trouble from occurring in an insulating layer.

A laminate production tool (10) is used for heating and pressurizing, in a chamber (50), a laminate before press bonding (1A) including a metal base substrate (2), a resin composition (3A) that is semi-cured, and a circuit body (C) that are laminated on top of each other, the circuit body (C) including a circuit pattern (4) or a mount body, the circuit pattern (4) having a thickness of 0.8 mm or more, the mount body including the circuit pattern (4) on which an electronic component is mounted. The laminate production tool (10) includes: a base jig (11) for attachment of the laminate before press bonding (1A); a film (13) that covers at least the resin composition (3A) and the circuit body (C); and a cover jig (12) that sandwiches the film (13) in cooperation with the base jig (11), in which the base jig (11) includes an outlet (11e) for exhaustion inside the film (13) that covers the resin composition (3A) and the circuit body (C), and the cover jig (12) includes an opening (12a) for exposure of an entire area of a covering part (13a) that covers the resin composition (3A) and the circuit body (C) in the film (13).

## Description

### Technical Field

The present invention relates to a laminate production tool and a laminate production method.

### Background Art

As a circuit board for mounting an electronic component, such as a semiconductor chip, a laminate including a metal base substrate, an insulating layer, and a circuit pattern that are laminated on top of each other has been conventionally known (for example, refer to Patent Literature 1). For production of such a type of laminate, for example, a resin and a filler are blended to prepare a resin composition. The resin composition is applied to a metal base substrate, followed by precuring. Then, a circuit pattern is mounted on the resin composition, followed by thermal pressing.

In recent years, electronic components through which a large current flows, such as a high-luminance LED and a power module, are often used. In order to obtain a laminate meeting a large current such that such a type of electronic component can be used, it is effective to reduce the value of resistance and to increase the thickness of a circuit pattern such that sufficient heat dissipation is ensured when a large current flows.

### Citation List

### Patent Literature

Patent Literature 1: JP 2002-012653 A
Patent Literature 2: JP 2009-206225 A

### Summary of Invention

### Technical Problem

In thermal pressing for production of a laminate, a resin composition in contact with conductive parts (metal parts) included in a circuit pattern is pressurized, whereas the resin composition at a gap part located between each adjacent conductive part is insufficiently pressurized because the resin composition is out of contact with the conductive parts at the gap part. That is, during thermal pressing, the pressure that the resin composition receives varies depending on whether or not the resin composition is in contact with the conductive parts. At a portion at which the gap part is located, the gas contained in the resin composition fails to be discharged due to insufficient pressurization and thus a large number of voids are generated, which may result in failure to ensure an insulating property. In particular, an increase in the thickness of the circuit pattern causes an increase in the depth of the gap part, leading to seriously insufficient pressurization. Thus, such a trouble occurs easily. At portions at which the conductive parts are located, the resin composition is strongly pressed due to the ends of the conductive parts (or a rapid change is made in pressure between the gap part and the conductive parts along the ends of the conductive parts), which may cause cracks at the time of formation as an insulating layer.

Note that, in order to subject a surface having irregularities to thermal pressing, a cushion that acts to fill the irregularities may be used (for example, refer to Patent Literature 2). However, in a case where the gap is deep in depth as above, even such a cushion has difficulty entering deeply in the gap, and thus insufficient pressurization may fail to be solved. In particular, in a case where the thickness of the circuit pattern is 0.8 mm or more, the frequency of occurrence of such a trouble is high.

In consideration of such problems, an object of the present invention is to provide a laminate production tool and a laminate production method for a laminate including a circuit pattern having a thickness of 0.8 mm or more, enabling prevention of a trouble from occurring in an insulating layer.

### Solution to Problem

According to the present invention, provided is a laminate production tool for use in heating and pressurizing, in a chamber, a laminate before press bonding including a metal base substrate, a resin composition that is semi-cured, and a circuit body that are laminated on top of each other for production of a laminate including the metal base substrate, an insulating layer, and the circuit body that are laminated in order, the insulating layer being formed by curing of the resin composition, the circuit body including a circuit pattern or a mount body, the circuit pattern having a thickness of 0.8 mm or more, the mount body including the circuit pattern on which an electronic component is mounted, the laminate production tool including: a base jig for attachment of the laminate before press bonding; a film that covers at least the resin composition and the circuit body; and a cover jig that sandwiches the film in cooperation with the base jig, in which the base jig includes an outlet for exhaustion inside the film that covers the resin composition and the circuit body, and the cover jig includes an opening for exposure of an entire area of a covering part that covers the resin composition and the circuit body in the film.

In the laminate production tool described above, preferably, the base jig includes: an accommodating part in which the laminate before press bonding is placeable inside; and a circumferential face located along a circumferential edge of the accommodating part, the circumferential face being located between a back face of the resin composition and a surface of the circuit pattern with the laminate before press bonding placed in the accommodating part.

Preferably, the laminate production tool described above further includes: a second film that covers at least a second resin composition and a second circuit body; and a second cover jig that sandwiches the second film in cooperation with the base jig, the second film and the second cover jig being for laminating the second resin composition that is semi-cured and the second circuit body having a thickness of 0.8 mm or more on a back side of the metal base substrate of the laminate before press bonding, the metal base substrate having a front side on which the resin composition and the circuit body are laminated, in which the second cover jig includes a second opening for exposure of an entire area of a second covering part that covers the second resin composition and the second circuit body in the second film.

According to the present invention, provided is a laminate production method using a laminate production tool for use in heating and pressurizing, in a chamber, a laminate before press bonding including a metal base substrate, a resin composition that is semi-cured, and a circuit body that are laminated on top of each other for production of a laminate including the metal base substrate, an insulating layer, and the circuit body that are laminated in order, the insulating layer being formed by curing of the resin composition, the circuit body including a circuit pattern or a mount body, the circuit pattern having a thickness of 0.8 mm or more, the mount body including the circuit pattern on which an electronic component is mounted, the laminate production tool including: a base jig for attachment of the laminate before press bonding; a film that covers at least the resin composition and the circuit body; and a cover jig that sandwiches the film in cooperation with the base jig, the base jig including an outlet for exhaustion inside the film that covers the resin composition and the circuit body, the cover jig including an opening for exposure of an entire area of a covering part that covers the resin composition and the circuit body in the film, the laminate production method including: a step of attaching the laminate before press bonding to the base jig, covering at least the resin composition and the circuit body with the film, and sandwiching the film by the base jig and the cover jig; and a step of placing the base jig and the cover jig between which the film is sandwiched in the chamber, and performing exhaustion inside the film through the outlet and raising a temperature and a pressure in the chamber to heat and pressurize the covering part exposed through the opening.

Preferably, the laminate production method described above further includes a step of heating the covering part exposed through the opening before placing the base jig and the cover jig between which the film is sandwiched in the chamber.

### Advantageous Effects of Invention

A laminate production tool and a laminate production method according to the present invention enable prevention of a trouble from occurring in an insulating layer in a laminate including a circuit pattern having a thickness of 0.8 mm or more.

### Brief Description of Drawings

Fig. 1 illustrates a laminate produced by a laminate production method according to an embodiment of the present invention.
Fig. 2 is a flowchart illustrating the laminate production method according to the embodiment of the present invention.
Fig. 3 illustrates an embodiment of a laminate production tool for use in the laminate production method illustrated in Fig. 1.
Fig. 4 illustrates a laminate produced by a laminate production method according to another embodiment of the present invention.
Fig. 5 illustrates an embodiment of a laminate production tool for use in the laminate production method illustrated in Fig. 4.
Fig. 6 illustrates an exemplary modified laminate production tool.

### Description of Embodiments

Embodiments of a laminate production tool and a laminate production method according to the present invention will be described below with reference to the accompanying drawings. Note that the illustrations in the accompanying drawings are schematic and thus, for example, the thickness or width of each part and the ratio between each part may be different from the actual ones. The following description is given based on the orientations of the illustrations, for convenience, but the orientation in use of the laminate production tool according to the present invention is not limited to the orientations.

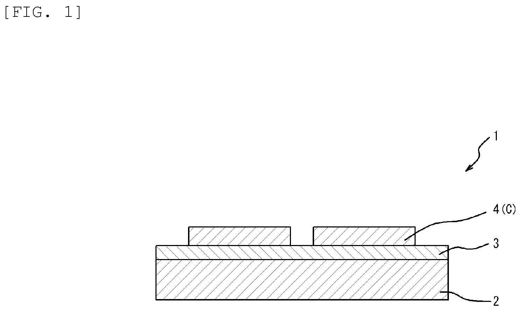

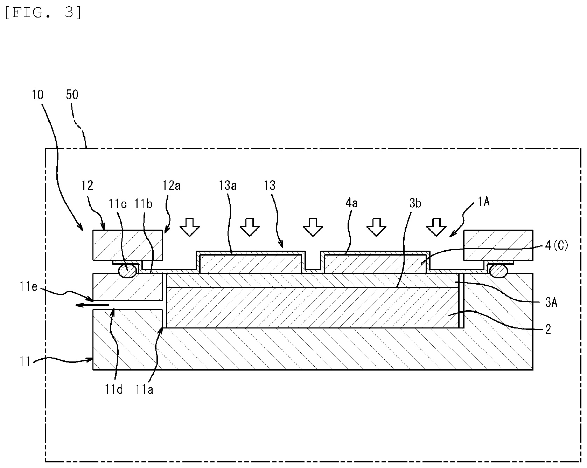

Fig. 1 illustrates a laminate 1 produced using a laminate production tool 10 and a chamber 50 illustrated in Fig. 3. The laminate 1 includes a metal base substrate 2, an insulating layer 3, and a circuit body C in this order. The circuit body C in the present embodiment includes a circuit pattern 4.

The metal base substrate 2 is formed of a metal, such as copper, aluminum, or iron (single metal or alloy). The metal base substrate 2 may have a single-layer structure or a multilayer structure, or may be formed of a single member or a plurality of members in combination. The metal base substrate 2 in the present embodiment is shaped like a plate but may be a heatsink provided with a comblike fin. The metal base substrate 2 may have a configuration for an improvement in the effect of dissipating heat outward and may be, for example, a metal plate in which a vapor chamber or a heat pipe is embedded.

The insulating layer 3 is formed of a material having an insulating property and is provided so as to cover the surface of the metal base substrate 2. The insulating layer 3 may cover the entire surface of the metal base substrate 2 or part of the surface.

The insulating layer 3 is formed of a resin composition containing a thermal curable resin. Examples of the thermal curable resin include an epoxy resin, a phenolic resin, a melamine resin, a urea formaldehyde resin, an unsaturated polyester resin, an alkyd resin, and a cyanate resin. As the thermal curable resin, one type of thermal curable resin may be used alone or two or more types of thermal curable resins may be used in combination.

As the epoxy resin, in general, a monomer, an oligomer, or a polymer having two or more epoxy groups in one molecule can be used, regardless of its molecular weight and molecular structure. Specific examples of such an epoxy resin include bisphenol epoxy resins such as a bisphenol-A epoxy resin, a bisphenol-F epoxy resin, a bisphenol-E epoxy resin, a bisphenol-S epoxy resin, a hydrogenated bisphenol-A epoxy resin, a bisphenol-M epoxy resin (4,4'-(1,3-phenylenediisopridiene) bisphenol epoxy resin), a bisphenol-P epoxy resin (4,4'-(1,4-phenylenediisopridiene) bisphenol epoxy resin), and a bisphenol-Z epoxy resin (4,4'-cyclohexadiene bisphenol epoxy resin); novolac epoxy resins such as a phenol novolac epoxy resin, a brominated phenol novolac epoxy resin, a cresol novolac epoxy resin, a tetraphenol-group ethane novolac epoxy resin, and a novolac epoxy resin having a condensed-ring aromatic hydrocarbon structure; a biphenyl epoxy resin; aralkyl epoxy resins such as a xylylene epoxy resin and a biphenyl aralkyl epoxy resin; epoxy resins having a naphthalene skeleton such as a naphthylene ether epoxy resin, a naphthol epoxy resin, a naphthalene epoxy resin, a naphthalene diol epoxy resin, a bifunctional or tetrafunctional epoxy naphthalene resin, a binaphthyl epoxy resin, and a naphthalene aralkyl epoxy resin; an anthracene epoxy resin; a phenoxy epoxy resin; a dicyclopentadiene epoxy resin; a norbornene epoxy resin; an adamantane epoxy resin; heterocyclic epoxy resins such as a fluorene epoxy resin, a phosphorus-containing epoxy resin, an alicyclic epoxy resin, an aliphatic chain epoxy resin, a bisphenol-A novolac epoxy resin, a bixylenol epoxy resin, a triphenol methane epoxy resin, a trihydroxyphenylmethane epoxy resin, a tetraphenylethane epoxy resin, and triglycidyl isocyanurate; glycidyl amines such as N,N,N',N'-tetraglycidylmetaxylenediamine, N,N,N',N'-tetraglycidylbisaminomethylcyclohexane, and N,N-diglycidylaniline; a copolymer of glycidyl (meth) acrylate and a compound having an ethylenically unsaturated double bond, an epoxy resin having a butadiene structure, diglycidyl etherified bisphenol, diglycidyl etherified naphthalenediol, and glycidyl etherified phenol. As the epoxy resin, one type of epoxy resin may be used alone or two or more types of epoxy resins may be used in combination.

The resin composition in the present embodiment contains a curing agent blended therein. The curing agent is not particularly limited, provided that the curing agent is selected depending on the type of the thermal curable resin and reacts with the thermal curable resin. Examples of the curing agent in a case where an epoxy resin is used include an amine-based curing agent, an imidazole-based curing agent, and a phenol-based curing agent.

The resin composition in the present embodiment contains a filler (inorganic filler) blended therein. The filler is preferably high in insulating property and high in thermal conductivity and examples thereof include aluminum oxide, silica, aluminum nitride, boron nitride, silicon nitride, and magnesium oxide. As the filler, one type of filler may be used alone or two or more types of fillers may be used in combination.

The resin composition in the present embodiment further contains a curing accelerator blended therein. Examples of the curing accelerator include, but are not particularly limited to, organometallic salts such as a benzoxazine compound, a borate complex, zinc naphthenate, cobalt naphthenate, tin octylate, cobalt octylate, bisacetylacetonate cobalt (II), and triacetylacetonate cobalt (III), phenol compounds such as phenol, bisphenol A, and nonylphenol, and a tertiary amine, a tertiary amine salt, phosphine, and a phosphonium salt.

The resin composition in the present embodiment contains a solvent blended therein. Examples of the solvent include, but are not particularly limited to, N-methylpyrrolidone, dimethylacetamide, tetrafluoroisopropanol, methyl ethyl ketone, ethylene diglycol acetate, propylene glycol monomethyl ether acetate, methyl isobutyl ketone, ethylene glycol monomethyl ether, tetrahydrofuran, chloroform, toluene, xylene, acetone, dioxane, and dimethyl sulfoxide.

The resin composition may contain an additive. Examples of the additive include a stabilizer, an ion scavenger, and a softness imparting agent.

A predetermined pattern is formed using a material having conductivity to obtain the circuit pattern 4. Examples of such a material include a metal plate of copper and a metal plate of aluminum. The thickness of the metal plate (thickness of the circuit pattern 4) is 0.8 mm or more. Note that the upper limit of the thickness of the metal plate (the thickness of the circuit pattern 4) is not particularly limited but is, for example, 2.0 mm or less. Examples of a method for forming a predetermined pattern using a metal plate include a method in which a mask pattern is formed on a metal plate and any exposed part of the metal plate is removed by etching and a method in which a metal plate is stamped using a die.

The circuit body C may be a mount body including an electronic component (chip) mounted on the circuit pattern 4, wiring connecting the electronic component and the circuit pattern 4, and a mold that is made of a synthetic resin and covers the electronic component and the wiring. Note that the thickness of the mount body with the mold covering is, for example, 5 mm.

Next, the respective configurations of the laminate production tool 10 and the chamber 50 will be described. The laminate production tool 10 includes a base jig 11, a cover jig 12, and a film 13.

In the present embodiment, the base jig 11 is formed of a metal. In the present embodiment, the base jig 11 is shaped like a rectangular parallelepiped as a whole and has its center provided with a recessed accommodating part 11a that is recessed downward. The accommodating part 11a is formed in a size such that a laminate before press bonding 1A (to be described in detail later) illustrated in Fig. 3 is placed inside. The upper face (circumferential face 11b) of the base jig 11 located along the circumferential edge of the accommodating part 11a is located at a height such that the upper face is flush with the surface of a resin composition 3A (to be described in detail later) that is semi-cured and is included in the laminate before press bonding 1A in a case where the laminate before press bonding 1A is placed in the accommodating part 11a. A packing member 11c formed of a material having elasticity (e.g., rubber or an elastomer) is provided outside the circumferential face 11b. The packing member 11c surrounds the entire circumference of the accommodating part 11a. Note that, although not illustrated, in order for the base jig 11 to hold the cover jig 12, female screw parts are provided outside the packing member 11c. The base jig 11 has a path 11d in communication with the accommodating part 11a through a side face of the base jig 11. An opening that the path 11d has on the side face of the base jig 11 is referred to as an outlet 11e.

In the present embodiment, the cover jig 12 is formed of a metal. In the present embodiment, the cover jig 12 is shaped like a rectangular parallelepiped as a whole and is thinner in thickness than the base jig 11, and the center thereof is provided with an opening 12a penetrating through the cover jig 12 in the up-down direction. The opening 12a is formed in a size substantially the same as that of the accommodating part 11a in plan view. In other words, the opening 12a is formed in a size such that the entire area of the resin composition 3A, which is semi-cured, is exposed in plan view. Note that the cover jig 12 in the present embodiment includes through holes, which are not illustrated, penetrating through the cover jig 12 in the up-down direction at positions corresponding to the female screw parts provided to the base jig 11, and screws, which are not illustrated, are inserted into the through holes and then are screwed into the female screw parts, so that the cover jig 12 is held by the base jig 11.

The film 13 is thin and has flexibility, and is, for example, a fluorine-based resin film.

Then, the chamber 50 includes a door, which is not illustrated, for opening or shutting the chamber 50, and ancillary facilities, which are not illustrated, such as a heater, a temperature sensor, a compressor, and a pressure sensor. The chamber 50 in the present embodiment energizes the heater with the door shut to raise the temperature in the chamber 50. The heater is operable in accordance with the temperature in the chamber 50 measured by the temperature sensor, and thus the inside of the chamber 50 can be set at a predetermined temperature. The chamber 50 in the present embodiment feeds the gas (e.g., air or nitrogen) pressurized by the compressor with the door shut to raise the pressure in the chamber 50. The compressor is operable in accordance with the pressure in the chamber 50 (or the pressure of compressed air being fed) measured by the pressure sensor, and thus the inside of the chamber 50 can be set at a predetermined pressure.

Note that, referring to Fig. 3, one laminate production tool 10 is placed in the chamber 50, but a plurality of laminate production tools 10 can be placed in the chamber 50.

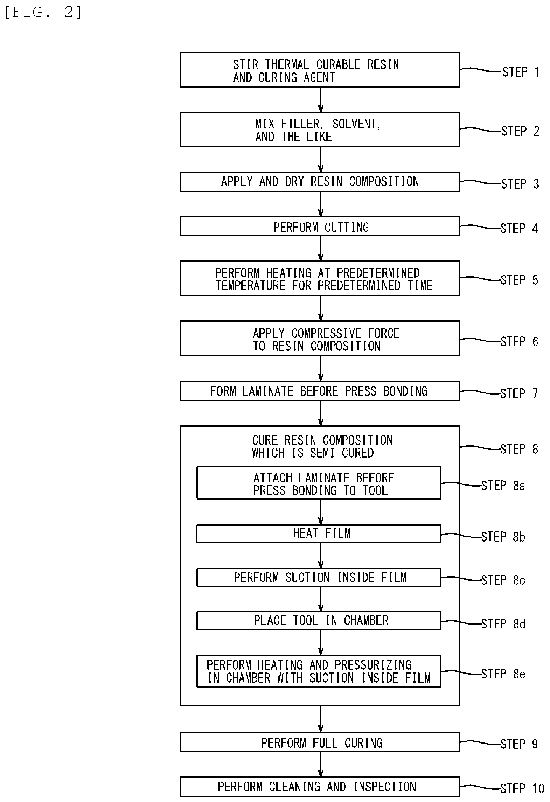

Next, a method for producing the laminate 1 will be described with reference to Figs. 2 and 3.

First, step 1 illustrated in Fig. 2 is performed. In step 1, a thermal curable resin and a curing agent are put into a container and then are stirred at a predetermined temperature for a predetermined time. Thus, the thermal curable resin and the curing agent can react with each other. Note that, depending on the temperature at the time of stirring and the duration of stirring, the thermal curable resin and the curing agent reacting with each other in step 1 can be pre-polymerized, but this case may be selected as appropriate in accordance with the degree of cure of the thermal curable resin in a step, which will be described later. Thus, in step 1, the thermal curable resin and the curing agent are not necessarily required to be pre-polymerized.

In step 2, the stirred thermal curable resin and curing agent, a filler, a curing accelerator, and a solvent are mixed together to generate a resin composition. Note that the resin composition in step 2 is semi-cured.

Then, in step 3, the generated resin composition is applied to the surface of a thin base member and is further dried to volatilize the solvent. The base member is not particularly limited, provided that the base member can be detached from the resin composition in a step, which will be described later. As an example, a long-shaped PET sheet can be used. Although there are no particular limitations in performing step 3, use of an apparatus including a feeder that feeds the long-shaped base member, a coater that is provided on the downstream side in the direction of feeding and applies the resin composition to the front side of the base member, and a heater that is provided on the upstream side in the direction of feeding and heats the passing resin composition at a predetermined temperature enables continuous applying and drying of the resin composition and thus is advantageous in that step 3 can be efficiently performed.

In step 4, the long-shaped base member to which the resin composition is applied is cut to a predetermined size to form a sheet-like sheet member including the resin composition and the base member laminated on top of each other. Note that, in a case where a base member cut to a predetermined size in advance is used in step 3, step 4 can be omitted.

Then, in step 5, the resin composition applied to the base member is heated at a predetermined temperature for a predetermined time. Thus, an increase can be made in the molecular weight (weight-average molecular weight) of the resin composition, which is semi-cured. Note that, although the molecular weight of the resin composition increases even in a step after step 5, increasing the molecular weight of the resin composition in advance in step 5 enables a reduction in the total time required for producing the laminate 1. In a case where the required molecular weight of the resin composition is already ensured in a step before step 5, step 5 may be omitted. As a specific example for performing step 5, a plurality of sheet members including the above-described resin composition and base member laminated on top of each other is prepared and then is collectively heated in a heating furnace.

In step 6, a compressive force is applied to the resin composition, which is semi-cured. The resin composition before step 6 is performed includes a large number of voids inside due to the drying in step 3. However, performing step 6 causes an increase in density to reduce the voids. Furthermore, the resin composition can have a high insulating property at the time of formation as an insulating layer due to a step, which will be described later. As a specific example for performing step 6, the above-described sheet member is laminated on the metal base substrate 2 illustrated in Fig. 1 with the resin composition in contact with the metal base substrate 2. Then, the sheet member laminated on the metal base substrate 2 is placed, for example, inside a vacuum press device. Then, with the device the inside of which is in a vacuum atmosphere at a predetermined temperature, the metal base substrate 2 and the sheet member, which are laminated on top of each other, are pressed. Thus, the resin composition, which is semi-cured, can be transferred to the metal base substrate 2 and additionally a compressive force can be applied to the resin composition. Note that, in order to perform step 6, the metal base substrate 2 is not necessarily required, and thus, for example, a separately prepared base member and the above-described sheet member may be laminated on top of each other and then be pressed or the sheet member may be pressed alone.

Performing a step of curing the resin composition, which is semi-cured (step 8), which will be described later, enables gas to be discharged from the resin composition. According to the inventors' studies, in a case where the degree of cure of the resin composition was excessive, although step 8 was performed, gas failed to be sufficiently discharged from the resin composition. Although step 8 was performed with the resin composition including a large number of voids inside because of its low density, the voids were difficult to reduce to such an extent that a sufficient withstand voltage was able to be obtained. According to repeated studies of respective optimum ranges of the molecular weight (weight average molecular weight) and density of the resin composition in consideration of the above-described point, a favorable result was obtained in a case where the rate of increase of the weight average molecular weight of the resin composition was 30% or less after step 6 (after a compressive force was applied) relative to before step 6 (before a compressive force was applied). According to further repeated studies, a more preferable result was obtained in a case where the rate of increase of the weight average molecular weight of the resin composition was 25% or less, and a further preferable result was obtained in a case where the rate of increase of the weight average molecular weight of the resin composition was 20% or less. A favorable result was obtained in a case where the density of the resin composition after step 6 (after a compressive force was applied) was 85% or more of the actual density of the finally formed insulating layer. Then, according to further repeated studies, a more preferable result was obtained in a case where the density of the resin composition was 90% or less and a further preferable result was obtained in a case where the density of the resin composition was 95% or less. Note that the weight average molecular weight is a polystyrene equivalent value measured by gel permeation chromatography (GPC).

Then, in step 7, the base member is detached from the resin composition, which is semi-cured, transferred to the metal base substrate 2. In a case where the resin composition is not transferred to the metal base substrate 2, the resin composition is transferred to the metal base substrate 2 and then the base member is detached from the resin composition. Then, the circuit body C (circuit pattern 4) illustrated in Fig. 1 is laminated on the resin composition to form a laminate before press bonding 1A (refer to Fig. 3). In this step, the circuit pattern laminated on the resin composition may be subjected to thermal pressing to cause the circuit pattern to temporarily adhere to the resin composition. Note that, referring to Fig. 3, the resin composition, which is semi-cured, is denoted with 3A as a reference sign.

In step 8, the resin composition 3A, which is semi-cured and is laminated in the laminate before press bonding 1A, is cured. In the present embodiment, using the laminate production tool 10 and the chamber 50 illustrated in Fig. 3, steps 8a to 8e illustrated in Fig. 2 are performed such that the resin composition 3A, which is semi-cured, is cured while gas is being discharged from the resin composition 3A. Note that, although Fig. 3 illustrates the laminate production tool 10 placed in the chamber 50, the work related to the laminate production tool 10 in the present embodiment is performed outside the chamber 50 in steps 8a to 8c in consideration of workability.

In step 8a, the laminate before press bonding 1A formed in step 7 is attached to the laminate production tool 10. Specifically, the laminate before press bonding 1A is inserted into the accommodating part 11a of the base jig 11 in a posture in which the metal base substrate 2 is located lower, so that the laminate before press bonding 1A is attached to the base jig 11. In this state, the circumferential face 11b of the base jig 11 is located at a height such that the circumferential face 11b is flush with the surface of the resin composition 3A.

After the laminate before press bonding 1A is attached to the base jig 11, the upper face of the laminate before press bonding 1A is covered with the film 13. In this case, the outer edge of the film 13 is located outside the packing member 11c. Thus, at least the surfaces of the circuit pattern 4 and the resin composition 3A in the laminate before press bonding 1A are covered with the film 13. After that, the cover jig 12 is attached to the base jig 11 using screws, which are not illustrated. Thus, the film 13 can be sandwiched between the packing member 11c of the base jig 11 and the cover jig 12. In this state, the entire area of a covering part (hereinafter, referred to as a covering part 13a) covering the surfaces of the resin composition 3A and the circuit pattern 4 in the film 13 is exposed through the opening 12a.

In step 8b, for example, a heating pad (pad having a heat built therein) is brought into contact with the film 13 through the opening 12a to heat the film 13. Thus, the covering part 13a can be softened. Since the opening 12a in the present embodiment is formed in a size substantially the same as that of the accommodating part 11a and the entire area of the covering part 13a described above is exposed, the entire area of the covering part 13a can be heated.

In step 8c, a pump, which is not illustrated, is connected to the outlet 11e to perform suction. Thus, exhaustion is performed inside the film 13 through the path 11d and the accommodating part 11a in communication with the outlet 11e, so that the film 13 can follow the shape of the surfaces of the circuit pattern 4 and the resin composition 3A. In the present embodiment, since the covering part 13a is softened in step 8b, the covering part 13a can follow the shape of the surfaces of the circuit pattern 4 and the resin composition 3A.

When the film 13 follows the shape of the surfaces of the circuit pattern 4 and the resin composition 3A as above, the film 13 can adhere not only to the surface of conductive parts (metal parts) included in the circuit pattern 4 but also to the resin composition 3A exposed at a gap part located between each adjacent conductive part because of entry to the gap part.

Note that the laminate production tool 10 in the present embodiment includes the accommodating part 11a and the surface of the resin composition 3A in the laminate before press bonding 1A attached to the laminate production tool 10 is flush with the circumferential face 11b, leaving almost no step in the height direction therebetween. Therefore, at the time of adhesion of the film 13, with its suppressed amount of elongation, the film 13 can adhere to the surfaces of the resin composition 3A and the circumferential face 11b. Note that the thickness of the metal base substrate 2 is often relatively thick and thus a large step is generated between the surface of the resin composition 3A and the circumferential face 11b in a case where no accommodating part 11a is provided. In this case, even in a case where exhaustion is performed inside the film 13 or the film 13 is heated, the film 13 may have difficulty following the shape of the step. In a case where the film 13 follows forcedly the shape of the step, the film 13 may be torn due to a problem of the amount of elongation of the film 13. On the other hand, in the present embodiment, such a trouble can be effectively prevented since the amount of elongation of the film 13 can be suppressed between the surface of the resin composition 3A and the circumferential face 11b as described above. Note that, in order to ensure the followability of the film 13 and prevent the film 13 from being torn, the circumferential face 11b is located preferably between the back face 3b of the resin composition 3A and the surface of the circuit body C (surface 4a of the circuit pattern 4 in the present embodiment) with the laminate before press bonding 1A placed in the accommodating part 11a.

In step 8d, the door, which is not illustrated, included in the chamber 50 is opened and the laminate production tool 10 subjected to step 8c is placed in the chamber 50. Then, the door is shut. Note that, before the laminate production tool 10 is placed in the chamber 50, the above-described heating pad is removed.

In step 8e, while suction is being performed with the pump, which is not illustrated, connected to the outlet 11e, the above-described heater and compressor are operated to raise the temperature and pressure in the chamber 50. Then, a state at a predetermined temperature and at a predetermined pressure is retained for a predetermined time, so that the resin composition 3A, which is semi-cured, can be cured. In the present embodiment, at the stage of being placed in the chamber 50, the film 13 adheres to the circuit pattern 4 and the resin composition 3A since the film 13 has already followed the shape of the surfaces of the circuit pattern 4 and the resin composition 3A. That is, since the film 13 adheres not only to the surface of the conductive parts included in the circuit pattern 4 but also to the resin composition 3A exposed at the gap part located between each conductive part because of entry to the gap part as described above, the temperature and pressure in the chamber 50 are effectively applied to the resin composition 3A exposed at the gap part. Since the laminate production tool 10 includes the opening 12a, the entire area of the covering part 13a is exposed in the chamber 50. That is, all of the surfaces of the circuit pattern 4 and the resin composition 3A can be uniformly heated at a predetermined temperature and uniformly pressurized at a predetermined pressure. Due to such action, gas can be more reliably discharged from the entire area of the resin composition 3A (e.g., gas contained in the voids or the remaining solvent, volatile low-molecular-weight components, or gas generated due to an effect reaction) and additionally the resin composition 3A, which is semi-cured, can be cured.

The laminate production tool 10 in the present embodiment includes the opening 12a and can be placed, for use, in the chamber 50 and thus is suitable for performing the work of curing the resin composition 3A, which is semi-cured, at a time for a plurality of laminates before press bonding 1A. That is, in order to feed pressurized and heated gas through the opening 12a reduced in size (reduced to approximately the size of the outlet 11e), for the work of curing the resin composition 3A, which is semi-cured, for a plurality of laminates before press bonding 1A, a connector for feeding the pressurized and heated gas is required to be attached to each opening 12a, leading to difficulty in workability. On the other hand, according to the laminate production tool 10 in the present embodiment, the temperature and pressure in the chamber 50 are applied to the laminate before press bonding 1A through the opening 12a. Thus, for the work of curing the resin composition 3A, which is semi-cured, for a plurality of laminates before press bonding 1A, a plurality of laminate production tools 10 each having a laminate before press bonding 1A attached thereto is only required to be placed in the chamber 50, leading to an enhancement in productivity.

Note that, for work for a plurality of laminates before press bonding 1A, for example, a modified laminate production tool 10 including a base jig 11 provided with a plurality of accommodating parts 11a and a cover jig 12 provided with a plurality of openings 12a may be used. In a case where a plurality of laminate production tools 10 each having one laminate before press bonding 1A attached thereto as illustrated is used, a manifold may be used to connect their outlets 11e together.

In order to perform step 8e as above, the pressure inside the chamber 50 is preferably 0.8 MPa or more and 3.0 MPa or less, the temperature inside the chamber 50 is preferably 100°C or more and 350°C or less, and the time for which the raised pressure and temperature are retained is preferably 1 minute or more and 90 minutes or less. Note that the pressure and temperature inside the chamber 50 can be changed in order for the curing of the resin composition 3A to proceed properly, and may be set so as to be kept constant for the above time or may be set so as to vary in accordance with the elapse of time.

Then, in step 9, the laminate 1 taken out from the chamber 50 is fully cured. As a specific example for performing step 9, the laminate 1 taken out from the chamber 50 is put into a heating furnace to heat the laminate 1 at a predetermined temperature for a predetermined time. Thus, the resin composition 3A, which is semi-cured, can be fully cured. Note that step 9 is performed in a case where the full curing of the resin composition 3A has not been completed in step 8. In a case where the resin composition 3A has been fully cured in step 8, step 9 is omitted.

In step 10, the laminate 1 including an insulating layer 3 resulting from the full curing of the resin composition 3A is subjected to cleaning, followed by various types of inspections.

According to examination of the laminate 1 produced due to steps 1 to 10 described above, it was found that the laminate 1 had a sufficient withstand voltage, as described in the following example. In addition, although the laminate 1 was repeatedly subjected to heating, no detachment was observed between the insulating layer 3 and the circuit pattern 4 and thus a favorable result was obtained.

An example of the present invention will be described below. Note that the present invention is not limited to the example.

### <Example>

A bisphenol-A epoxy resin (produced by DIC Corporation) as a thermal curable resin, diethyltoluenediamine (produced by Lonza K.K.) as a curing agent, aluminum oxide, an aggregate of boron nitride, and a fine powder of boron nitride as a filler, triphenylphosphine (produced by HOKKO CHEMICAL INDUSTRY CO., LTD) as a curing accelerator, and ethyl 3-ethoxypropionate as a solvent were prepared.

Then, the thermal curable resin and the curing agent were stirred at 70°C for 11 hours so as to be pre-polymerized (step 1). Next, the thermal curable resin, which was pre-polymerized, was blended with the above-described filler, curing accelerator, and solvent and then was mixed by a mixer to generate a resin composition that is semi-cured (step 2).

Then, the weight average molecular weight of the resin composition after step 2 was measured. The measured weight average molecular weight was a polystyrene equivalent value measured by gel permeation chromatography (GPC). The measurement was performed using tetrahydrofuran (THF) as a mobile phase.
Measurement equipment: Waters e2695 Separations Module
Differential refractive index (RI) detector: Waters 2414 RI Detector
Column: TSKgel guardcolumnH
Column: TSKgel G1000H
Column: TSKgel G2000H
Column: TSKgel G3000H

Note that the weight average molecular weight of the resin composition after step 2 was 487.

Then, the generated resin composition was applied to a long-shaped PET sheet and then was subjected to heating at 80°C for 40 minutes (step 3). After that, the PET sheet to which the resin composition was applied was cut to a predetermined size (step 4). After that, the cut sheet member was subjected to heating at 80°C for 20 minutes (step 5).

Then, the weight average molecular weight and density of the resin composition after step 5 were measured. A method for measuring the weight average molecular weight was the same as that after step 2. The density was measured by the Archimedes' method using the Analytical Balance HR-250AZ and the Density Determination Kit AD-1653 produced by A&D Company, Ltd. In this case, the weight average molecular weight and density of the resin composition were 1700 and 1.87 g/cm³, respectively. Note that the actual density of an insulating layer resulting from the full curing of the resin composition after step 10 was 2.10 g/cm³ according to measurement by the above Archimedes' method.

Then, the sheet member after step 5 was laminated on a metal base substrate with the resin composition in contact with the metal base substrate and then was placed inside a vacuum press device. Then, with the device having its inside in a vacuum atmosphere at 90°C, the metal base substrate and the sheet member, which were laminated on top of each other, were subjected to pressing at 23 MPa for 30 seconds (step 6).

Then, the weight average molecular weight and density of the resin composition after step 6 were measured. Methods for measuring the weight average molecular weight and density were the same as those after step 5. In this case, the weight average molecular weight and density of the resin composition were 1900 and 2.00 g/cm³, respectively. That is, in the present example, the rate of increase of the weight average molecular weight of the resin composition before and after the step of applying a compressive force was 11.8% due to calculation of the following expression: ((1900 - 1700)/1700) × 100%. In the present example, the density of the resin composition after the step of applying a compressive force was 95.2% of the actual density of the insulating layer due to calculation of the following expression: (2.00/2.10) × 100%.

Next, the PET sheet was detached from the resin composition, which was semi-cured, transferred to the metal base substrate, and furthermore a circuit pattern (having a thickness of 1 mm) was laminated on the resin composition to form a laminate before press bonding (step 7).

After that, as illustrated in Fig. 3, the laminate before press bonding was attached to the laminate production tool (step 8a). The film was heated through the opening of the cover jig (step 8b). Exhaustion was performed inside the film covering the laminate before press bonding (step 8c). After that, the laminate production tool having the laminate before press bonding attached thereto was placed in the chamber (step 8d). Then, the temperature and pressure in the chamber were raised while exhaustion was being performed inside the film covering the laminate before press bonding (step 8e).

In step 8b described above, the temperature at which the film was heated was 110°C and the duration of heating was 30 seconds. In step 8c, the film was also heated at 110°C for 30 seconds while exhaustion was being performed inside the film. In step 8e, the temperature was 170°C and the duration of heating was 10 minutes (total time of the time taken for a rise in temperature and the time for which the temperature was retained).

Next, the laminate taken out from an autoclave was heated in a non-pressurized (atmospheric pressure) state at 185°C for 1 hour (step 9). After that, the laminate was subjected to cleaning, followed by predetermined inspection (step 10).

Then, such laminates produced due to steps 1 to 10 were subjected to a withstand voltage test. No abnormality was observed from each laminate produced under the conditions described above although a voltage of 3 to 9 kV was applied, and thus the result was favorable. The produced laminates were internally observed by scanning acoustic tomography (SAT) after heating at 300°C for 5 minutes (after the first heating), and no detachment was observed between the insulating layer and the circuit pattern in any of the laminates. Then, even after heating again at 300°C for 5 minutes (after the second heating) and after further heating at 300°C for 5 minutes (after the third heating), no detachment was observed between the insulating layer and the circuit pattern in any of the produced laminates, and thus the result was favorable.

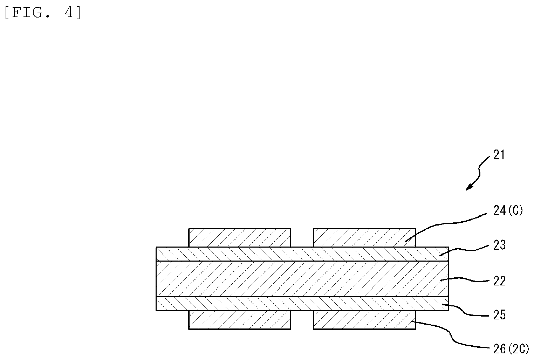

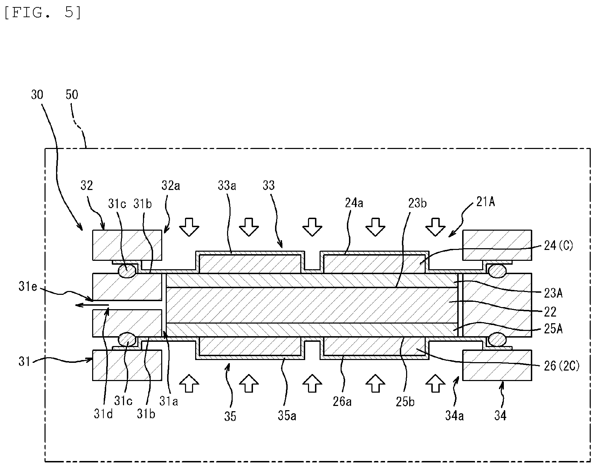

The present invention can be also applied to production of a laminate 21 illustrated in Fig. 4. The laminate 21 includes not only a metal base substrate 22, an insulating layer 23, and a circuit body C (circuit pattern 24 in the present embodiment), which are similar in configuration to the above-described metal base substrate 2, insulating layer 3, and circuit body C (circuit pattern 4 in the above-described embodiment), but also a second insulating layer 25 and a second circuit body 2C (second circuit pattern 26 in the present embodiment) on the opposite side to the side on which the metal base substrate 22 has the insulating layer 23 and the circuit pattern 24 provided. The laminate 21 is produced from a laminate before press bonding 21A illustrated in Fig. 5. The laminate before press bonding 21A includes a resin composition 23A and a second resin composition 25A that are semi-cured and are to be the insulating layer 23 and the second insulating layer 25, respectively, by curing. The resin composition 23A and the second resin composition 25A, which are semi-cured, are produced using a material similar to that of the above-described resin composition 3A, which is semi-cured, and the circuit pattern 24 and the second circuit pattern 26 are produced using a material similar to that of the above-described circuit pattern 4. Note that the circuit body C and the second circuit body 2C may be each the above-described mount body. For production of the laminate before press bonding 21A, the resin composition 23A and the second resin composition 25A are provided in the step of providing the resin composition 3A for the laminate before press bonding 1A described above and the circuit pattern 24 and the second circuit pattern 26 are provided in the step of providing the circuit pattern 4. That is, similarly to the laminate before press bonding 1A, the above-described steps 1 to 7 are performed to produce the laminate before press bonding 21A.

For production of the laminate 21 from the laminate before press bonding 21A, a laminate production tool 30 illustrated in Fig. 5 is used. The laminate production tool 30 in the present embodiment includes a base jig 31, a cover jig 32, a film 33, a second cover jig 34, and a second film 35.

The base jig 31 is shaped like the base jig 11 described above from which its bottom is removed and has its center provided with an accommodating part 31a that is rectangular in shape in plan view and penetrates through the base jig 31 in the up-down direction. Then, the base jig 31 has an upper face and a lower face (upper circumferential face 31b and lower circumferential face 31b) that are located along the circumferential edge of the accommodating part 31a and are located at heights such that the upper face and the lower face are flush with the surface of the resin composition 23A and the surface of the second resin composition 25A, respectively, with the laminate before press bonding 21A placed in the accommodating part 31a. Note that, similarly to the above-described laminate production tool 10, in the present embodiment, in order to ensure the followability of the film 33 and the second film 35 and prevent the film 33 and the second film 35 from being torn, the upper circumferential face 31b is located preferably between the back face 23b of the resin composition 23A and the surface of the circuit body C (surface 24a of the circuit pattern 24 in the present embodiment) and the lower circumferential face 31b is located preferably between the back face 25b of the second resin composition 25A and the surface of the second circuit body 2C (surface 26a of the second circuit pattern 26 in the present embodiment) with the laminate before press bonding 21A placed in the accommodating part 31a. A packing member 31c provided outside the circumferential face 31b is formed of a material having elasticity and surrounds the entire circumference of the accommodating part 31a. Although not illustrated, in order for the base jig 31 to hold the cover jig 32 and the second cover jig 34, female screw parts are provided outside the packing member 31c. Furthermore, the base jig 31 includes a path 31d and an outlet 31e that are similar in configuration to the above-described path 11d and outlet 11e.

In the present embodiment, the cover jig 32 and the second cover jig 34 are identical in shape to the above-described cover jig 12. An opening provided to the center of the cover jig 32 is referred to as an opening 32a and an opening provided to the second cover jig 34 is referred to as a second opening 34a.

Then, in the embodiment, the film 33 and the second film 35 are formed of a material the same as that of the above-described film 13. The film 33 and the second film 35 are thin and have flexibility.

For attachment of the laminate before press bonding 21A to the laminate production tool 30, after the laminate before press bonding 21A is placed in the accommodating part 31a, the cover jig 32 is attached to the base jig 31 using screws, which are not illustrated, with the film 33 covering the surfaces of the circuit pattern 24 and the resin composition 23A and the second cover jig 34 is attached to the base jig 31 using screws, which are not illustrated, with the second film 35 covering the surfaces of the second circuit pattern 26 and the second resin composition 25A (step 8a). In this state, the entire area of a covering part 33a covering the surfaces of the resin composition 23A and the circuit pattern 24 in the film 33 is exposed through the opening 32a, and the entire area of a second covering part 35a covering the surfaces of the second resin composition 25A and the second circuit pattern 26 in the second film 35 is exposed through the second opening 34a.

Then, a heating pad is brought into contact with the film 33 through the opening 32a to heat the film 33 and additionally a heating pad is brought into contact with the second film 35 through the second opening 34a to heat the second film 35. Furthermore, a pump, which is not illustrated, is connected to the outlet 31e to perform suction. Thus, the film 33 can adhere to the entire surface of the resin composition 23A and the second film 35 can adhere to the entire surface of the second resin composition 25A (steps 8b and 8c).

After that, the laminate production tool 30 subjected to the above-described steps is placed in the chamber 50, and the temperature and pressure in the chamber 50 are raised while suction is being performed through the outlet 31e. Thus, while gas is being discharged from the entire areas of the resin composition 23A and the second resin composition 25A, the resin composition 23A and the second resin composition 25A, which are semi-cured, can be cured (steps 8d and 8e).

After that, a step of fully curing the laminate 21 taken out from the chamber 50 is performed as necessary (step 9), and cleaning and inspection are performed (step 10), so that the laminate 21 illustrated in Fig. 4 can be produced.

Embodiments of the present invention have been described above, but the present invention is not limited to such particular embodiments. Unless otherwise particularly limited in the above description, various modifications and alterations can be made without departing from the scope of the gist of the present invention described in the claims. The effects in the above embodiments are merely exemplified as effects due to the present invention and thus do not mean that effects according to the present invention are limited to the above effects.

For example, the packing member 11c illustrated in Fig. 3 is provided to the base jig 11 in the above-described corresponding embodiment, but may be provided to the cover jig 12.

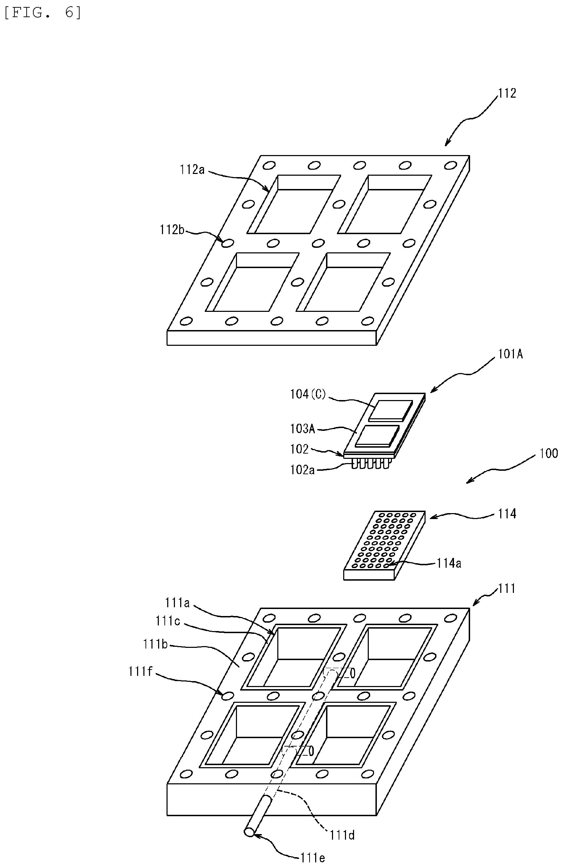

Then, the above-described modified laminate production tool including a base jig 11 provided with a plurality of accommodating parts 11a and a cover jig 12 provided with a plurality of openings 12a for work for a plurality of laminates before press bonding may have a configuration like a laminate production tool 100 illustrated in Fig. 6, for example.

The laminate production tool 100 illustrated in Fig. 6 is used when a laminate before press bonding 101A is heated and pressurized in the chamber 50, instead of the above-described laminate before press bonding 1A. The laminate before press bonding 101A includes a metal base substrate 102, a resin composition 103A that is semi-cured, and a circuit pattern 104 (circuit body C) that are similar to the metal base substrate 2, the resin composition 3A, which is semi-cured, and the circuit pattern 4 (circuit body C) included in the laminate before press bonding 1A. Note that the metal base substrate 102 has a lower face provided with a plurality of cylindrical fins 102a.

The laminate production tool 100 includes not only a base jig 111, a cover jig 112, and an intermediate jig 114 but also the above-described film (not illustrated in Fig. 6). The laminate production tool 100 in the present embodiment enables attachment of four laminates before press bonding 101A in total.

In the present embodiment, the base jig 111 is made of metal and is shaped like a rectangular parallelepiped as a whole, as illustrated. The base jig 111 is provided with a plurality of recessed accommodating parts 111a that is recessed downward (four in the present embodiment). The accommodating parts 111a are each formed in a size such that the laminate before press bonding 101A and the intermediate jig 114 are placed inside. The upper face (circumferential face 111b) of the base jig 111 located for each of the circumferential edges of the accommodating parts 111a is located at a height such that, with the laminate before press bonding 101A that has the intermediate jig 114 attached thereto being placed in the corresponding accommodating part 111a, the upper face is flush with the surface of the resin composition 103A, which is semi-cured, included in the laminate before press bonding 101A. A packing member 111c provided outside each circumferential face 111b is formed of a material having elasticity (e.g., rubber or an elastomer) and surrounds the entire circumference of the corresponding accommodating part 111a. Female screw parts 111f are provided outside each packing member 111c in order for the base jig 111 to hold the cover jig 112. A path 111d in communication with the plurality of accommodating parts 111a is provided inside the base jig 111, and the path 111d is in communication with an outlet 111e provided to a side face of the base jig 111.

In the present embodiment, the cover jig 112 is made of metal and is shaped like a rectangular parallelepiped as a whole, as illustrated. The cover jig 112 includes a plurality of openings 112a penetrating therethrough in the up-down direction (four in the present embodiment), and each opening 112a is formed in a size substantially the same as the size of each accommodating part 111a in plan view. In other words, each opening 112a is formed in a size such that the entire area of the resin composition 103A, which is semi-cured, is exposed in plan view. The cover jig 112 includes through holes 112b penetrating through the cover jig 112 in the up-down direction at positions corresponding to the female screw parts 111f provided to the base jig 111.

In the present embodiment, the intermediate jig 114 is made of metal and is shaped like a rectangular parallelepiped as a whole, as illustrated. The intermediate jig 114 includes a plurality of circular holes (escape holes 114a) penetrating therethrough in the up-down direction. The escape holes 114a enable insertion of the fins 102a included in the metal base substrate 102. With the fins 102a inserted in the escape holes 114a, the metal base substrate 102 is supported by the intermediate jig 114. Note that one intermediate jig 114 is prepared for one laminate before press bonding 101A.

For heating and pressurizing of a plurality of laminates before press bonding 101A using laminate production tools 100 in the chamber 50, the above-described steps 1 to 7 are performed to prepare a plurality of laminates before press bonding 101A. Then, intermediate jigs 114 are attached one-to-one to the plurality of laminates before press bonding 101A and then the above-described steps 8a to 8c are performed. Specifically, the laminates before press bonding 101A having the intermediate jigs 114 attached thereto are placed in the accommodating parts 111a and the upper faces of the laminates before press bonding 101A are covered with the film, which is not illustrated. Then, screws, which are not illustrated, inserted in the through holes 112b are screwed into the female screw parts 111f to attach the cover jig 112 to the base jig 111. In this case, the film is sandwiched between the packing members 111c and the cover jig 112. Then, a heating pad is brought into contact with the film through the openings 112a to heat the film and furthermore a pump, which is not illustrated, is connected to the outlet 111e to perform suction, so that the film follows the shape of the surfaces of the circuit pattern 104 and the resin composition 103A included in each laminate before press bonding 101A. After that, step 8d and the following step are performed, so that the plurality of laminates before press bonding 101A can be heated and pressurized at a time.

### Reference Signs List

1, 21 laminate
1A, 21A, 101A laminate before press bonding
2, 22, 102 metal base substrate
3, 23 insulating layer
3A, 23A, 103A resin composition
4, 24, 104 circuit pattern
10, 30, 100 laminate production tool
11, 31, 111 base jig
11a, 31a, 111a accommodating part
11b, 31b, 111b circumferential face
11e, 31e, 111e outlet
12, 32, 112 cover jig
12a, 32a, 112a opening
13, 33 film
13a, 33a covering part
34 second cover jig
34a second opening
35 second film
35a second covering part
50 chamber
C circuit body
2C second circuit body

## Claims

1. A laminate production tool for use in heating and pressurizing, in a chamber, a laminate before press bonding including a metal base substrate, a resin composition that is semi-cured, and a circuit body that are laminated on top of each other for production of a laminate including the metal base substrate, an insulating layer, and the circuit body that are laminated in order, the insulating layer being formed by curing of the resin composition, the circuit body including a circuit pattern or a mount body, the circuit pattern having a thickness of 0.8 mm or more, the mount body including the circuit pattern on which an electronic component is mounted, the laminate production tool comprising:
a base jig for attachment of the laminate before press bonding;
a film that covers at least the resin composition and the circuit body; and
a cover jig that sandwiches the film in cooperation with the base jig,
wherein
the base jig includes an outlet for exhaustion inside the film that covers the resin composition and the circuit body, and
the cover jig includes an opening for exposure of an entire area of a covering part that covers the resin composition and the circuit body in the film.

2. The laminate production tool according to claim 1, wherein the base jig includes:
an accommodating part in which the laminate before press bonding is placeable inside, and
a circumferential face located along a circumferential edge of the accommodating part, the circumferential face being located between a back face of the resin composition and a surface of the circuit body with the laminate before press bonding placed in the accommodating part.

3. The laminate production tool according to claim 1, further comprising:
a second film that covers at least a second resin composition and a second circuit body, and
a second cover jig that sandwiches the second film in cooperation with the base jig, the second film and the second cover jig being for laminating the second resin composition that is semi-cured and the second circuit body having a thickness of 0.8 mm or more on a back side of the metal base substrate of the laminate before press bonding, the metal base substrate having a front side on which the resin composition and the circuit body are laminated,
wherein the second cover jig includes a second opening for exposure of an entire area of a second covering part that covers the second resin composition and the second circuit body in the second film.

4. A laminate production method using a laminate production tool for use in heating and pressurizing, in a chamber, a laminate before press bonding including a metal base substrate, a resin composition that is semi-cured, and a circuit body that are laminated on top of each other for production of a laminate including the metal base substrate, an insulating layer, and the circuit body that are laminated in order, the insulating layer being formed by curing of the resin composition, the circuit body including a circuit pattern or a mount body, the circuit pattern having a thickness of 0.8 mm or more, the mount body including the circuit pattern on which an electronic component is mounted,
the laminate production tool including:
a base jig for attachment of the laminate before press bonding;
a film that covers at least the resin composition and the circuit body; and
a cover jig that sandwiches the film in cooperation with the base jig, the base jig including an outlet for exhaustion inside the film that covers the resin composition and the circuit body, the cover jig including an opening for exposure of an entire area of a covering part that covers the resin composition and the circuit body in the film,
the laminate production method comprising:
a step of attaching the laminate before press bonding to the base jig, covering at least the resin composition and the circuit body with the film, and sandwiching the film by the base jig and the cover jig; and
a step of placing the base jig and the cover jig between which the film is sandwiched in the chamber, and performing exhaustion inside the film through the outlet and raising a temperature and a pressure in the chamber to heat and pressurize the covering part exposed through the opening.

5. The laminate production method according to claim 4, further comprising a step of heating the covering part exposed through the opening before placing the base jig and the cover jig between which the film is sandwiched in the chamber.
